# FASCICULE DE BREVET EUROPEEN

(11) **EP 3 674 717 B1**
(45) Date de publication et mention de la délivrance du brevet: **05.07.2023**
(21) Numéro de dépôt: 19220293.5
(22) Date de dépôt: 31.12.2019
(51) Int. Cl.: G01R 23/16

(54) **DISPOSITIF POUR LA DETERMINATION DU SPECTRE D'UN SIGNAL SUR UNE LARGE BANDE DE FREQUENCES PAR ECHANTILLONNAGES MULTIPLES ET PROCEDE ASSOCIE**
VORRICHTUNG ZUR BESTIMMUNG DES SPEKTRUMS EINES SIGNALS ÜBER EINE GROSSE FREQUENZBANDBREITE DURCH MEHRFACHABTASTUNG, UND ENTSPRECHENDES VERFAHREN
DEVICE FOR DETERMINING THE SPECTRUM OF A SIGNAL ON A WIDE FREQUENCY BAND BY MULTIPLE SAMPLES AND ASSOCIATED METHOD

(30) Priorité: 31.12.2018 FR 1874397
(43) Date de publication de la demande: 01.07.2020
(73) Titulaire: Avantix, 13100 Aix-en-Provence (FR)
(72) Inventeur: BUSI, Jean-Daniel, 13100 Aix-en-Provence (FR)
(74) Mandataire: Cabinet Camus Lebkiri

(56) Documents cités:
- US-A1- 2017 336 450
- US-A1- 2018 083 816
- HUANG SHAN ET AL: "Frequency estimation of multiple sinusoids with three sub-Nyquist channels", SIGNAL PROCESSING, ELSEVIER SCIENCE PUBLISHERS B.V. AMSTERDAM, NL, vol. 139, 17 avril 2017 (2017-04-17), pages 96-101, XP085008642, ISSN: 0165-1684, DOI: 10.1016/J.SIGPRO.2017.04.013

## Description

### DOMAINE TECHNIQUE DE L'INVENTION

Le domaine technique de l'invention est celui de l'analyse d'une large bande de fréquences et en particulier celui de la détermination du spectre de signaux sur une large bande de fréquences.

La présente invention concerne un dispositif pour l'analyse d'une large bande de fréquences et en particulier un dispositif pour la détermination du spectre de signaux sur une large bande de fréquences.

### ARRIERE-PLAN TECHNOLOGIQUE DE L'INVENTION

Pour augmenter la probabilité d'interception de signaux par des récepteurs, il est courant d'utiliser des récepteurs de type large bande plutôt que des récepteurs de type bande étroite qui peuvent détecter uniquement sur la bande étroite correspondante.

Pour des applications de surveillance du spectre radioélectrique ou de détection d'émetteurs, il est indispensable de déterminer le spectre des signaux reçus, par exemple pour identifier ou localiser un émetteur particulier.

Or, il est difficile pour un unique récepteur de reconstituer le spectre entier d'un signal sur une large bande de fréquences. Par exemple, un récepteur superhétérodyne va filtrer le signal pour n'en garder qu'une bande étroite, estimer le spectre du signal correspondant à cette bande étroite et recommencer le processus précédent pour chaque bande étroite constituant la large bande. Bien que permettant d'obtenir des estimations précises, un tel processus ne permet pas d'analyser rapidement le spectre du signal reçu, ce qui diminue la probabilité d'interception d'autres signaux émis simultanément ou successivement. Une solution possible est alors de réaliser le même processus N fois en parallèle mais ceci suppose alors de multiplier par N le nombre d'équipements, ce qui est coûteux et contraignant quand le récepteur doit être embarqué.

Il existe donc un besoin d'un dispositif moins onéreux pouvant être embarqué et permettant de déterminer le spectre de tous les signaux reçus sur une large bande de fréquences, qu'ils soient reçus simultanément ou consécutivement, de manière précise.

« Le document US 2017/336450 intitulé « Method for detecting signals in a frequency-ambiguous digital receiver, and digital receiver implementing such a method », le document US 2018/083816 intitulé « Methods and apparatus for array-based compressed sensing » et le document « Frequency estimation of multiple sinusoids with three sub-Nyquist channels", Huang et al., Signal processing, Elsevier, sont connus de l'état de la technique. »

### RESUME DE L'INVENTION

L'invention offre une solution aux problèmes évoqués précédemment, en permettant de déterminer précisément, sur une large bande de fréquences, le spectre de chaque signal reçu avec un dispositif embarquable.

Un premier aspect de l'invention concerne un dispositif pour la détermination du spectre d'au moins un signal émis sur une bande de fréquences de signal connue comprise dans une large bande de fréquences comportant :
- un module de réception configuré pour recevoir au moins un signal sur une large bande de fréquences ayant une fréquence maximale ;
- un module de traitement comprenant :
   ∘ une pluralité de convertisseurs analogiques-numériques en parallèle configurés pour réaliser l'échantillonnage du signal reçu à des fréquences d'échantillonnage différentes pour obtenir une pluralité de signaux échantillonnés, les fréquences d'échantillonnage étant inférieures ou égales à deux fois la fréquence maximale et supérieures ou égales à deux fois la largeur de la bande de fréquences de signal ;
   ∘ une unité de calcul configurée pour déterminer le spectre du signal reçu à partir des spectres des signaux échantillonnés.

Grâce à l'invention, le spectre d'un signal reçu sur une large bande de fréquences est déterminé grâce au spectre de chaque signal échantillonné soumis au phénomène de repliement de spectre car échantillonné par une fréquence ne respectant pas le théorème de Shannon. En recoupant les différents spectres des signaux échantillonnés soumis au repliement de spectre, il est alors possible de remonter de manière précise au spectre du signal reçu avec un dispositif peu onéreux et peu encombrant. De plus, comme les opérations d'échantillonnage sont réalisées en parallèle, la détermination du spectre du signal reçu est rapide comparée à celle qui est réalisée par un récepteur superhétérodyne et permet donc par exemple de traiter deux signaux reçus simultanément sur toute la bande d'écoute.

En choisissant des fréquences d'échantillonnages supérieures à deux fois la largeur de bandes du signal, il est possible, en plus de déterminer le spectre du signal reçu, d'extraire le signal reçu à partir des signaux échantillonnés. En effet, pour chaque signal reçu, le théorème de Shannon doit être respecté afin de conserver l'ensemble des informations dans les données échantillonnées. Il faut donc que chaque fréquence d'échantillonnage soit supérieure à la largeur de bande du signal reçu. L'extraction du signal brut peut alors être réalisée, par exemple en réalisant la transformée de Fourier inverse à partir de la transformée de Fourier d'une des voies d'acquisition voire de la reconstruction du spectre grâce à l'ensemble des données échantillonnées.

Ainsi, les fréquences d'échantillonnage sont choisies pour que le théorème de Shannon soit respecté pour le signal reçu mais que le théorème de Shannon ne soit pas respecté pour le spectre du signal reçu.

Outre les caractéristiques qui viennent d'être évoquées dans le paragraphe précédent, le dispositif selon un premier aspect de l'invention peut présenter une ou plusieurs caractéristiques complémentaires parmi les suivantes, considérées individuellement ou selon toutes les combinaisons techniquement possibles.

Avantageusement, les signaux sont reçus sur une bande de fréquences d'étendant de 0 MHz et 100 GHz.

Avantageusement, le module de traitement comprend au moins trois convertisseurs analogiques-numériques.

Ainsi, le dispositif permet une détermination précise du spectre du signal reçu.

Avantageusement, les fréquences d'échantillonnage sont choisies de manière que leur plus petit commun multiple soit plus grand que la fréquence maximale de la large bande de fréquences.

Ainsi, on évite les risques d'ambiguïté lors de la détermination du spectre du signal reçu à partir des spectres des signaux échantillonnés.

Selon l'invention, les fréquences d'échantillonnage sont choisies de manière à être espacées deux à deux d'une valeur supérieure à deux fois la largeur de bandes du signal.

En choisissant des fréquences d'échantillonnages dont l'espacement, c'est-à-dire la différence minimale entre les fréquences d'échantillonnage, est supérieur à deux fois la largeur de bandes du signal, il est possible, en plus de déterminer le spectre du signal reçu, d'extraire le signal reçu à partir d'au moins un des signaux échantillonnés quelle que soit la fréquence du signal dans le spectre. En effet, dans ce cas, le signal ne sera pas replié entre deux bandes de Nyquist sur au moins un des convertisseurs analogiques-numériques permettant d'extraire de ses données échantillonnées le signal brut, par filtrage par exemple.

Un deuxième aspect de l'invention concerne un procédé de détermination du spectre d'au moins un signal émis sur une bande de fréquences de signal comprise dans une large bande de fréquences ayant une fréquence maximale, mis en oeuvre par le dispositif selon un premier aspect de l'invention, comportant les étapes suivantes :
- une étape de réception du signal réalisée par le module de réception ;
- une étape d'échantillonnage du signal reçu réalisée par chaque convertisseur analogique-numérique du module de traitement, les convertisseurs analogiques-numériques utilisant des fréquences d'échantillonnages différentes, inférieures ou égales à deux fois la fréquence maximale et fournissant chacun un signal échantillonné et supérieures ou égales à deux fois la largeur de la bande de fréquences de signal ;
- une étape de calcul du spectre de chaque signal échantillonné réalisée par l'unité de calcul ;
- une étape de détermination du spectre du signal reçu à partir des spectres des signaux échantillonnés réalisée par l'unité de calcul.

Un troisième aspect de l'invention concerne un produit programme d'ordinateur comprenant des instructions qui, lorsque le programme est exécuté par un ordinateur, conduisent celui-ci à mettre en oeuvre le procédé selon un deuxième aspect de l'invention.

Un quatrième aspect de l'invention concerne un support d'enregistrement lisible par ordinateur comprenant des instructions qui, lorsqu'elles sont exécutées par un ordinateur, conduisent celui-ci à mettre en oeuvre le procédé selon un deuxième aspect de l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique du dispositif selon un premier aspect de l'invention.
- La figure 2 montre une représentation schématique du procédé selon un deuxième aspect de l'invention.
- La figure 3 représente le spectre réel d'un signal reçu et le spectre du même signal obtenu après échantillonnage avec une fréquence ne respectant pas le théorème de Shannon.
- La figure 4A montre le spectre d'un signal échantillonné à une fréquence Fₑ égale à 100 Hz soumis au phénomène de repliement de spectre.
- La figure 4B montre le spectre d'un signal échantillonné à une fréquence Fₑ égale à 120 Hz soumis au phénomène de repliement de spectre.
- La figure 4C montre le spectre d'un signal échantillonné à une fréquence Fₑ égale à 130 Hz soumis au phénomène de repliement de spectre.

### DESCRIPTION DETAILLEE D'AU MOINS UN MODE DE REALISATION DE L'INVENTION

Sauf précision contraire, un même élément apparaissant sur des figures différentes présente une référence unique.

Un premier aspect de l'invention concerne un dispositif 100 permettant de déterminer le spectre de signaux sur une large bande de fréquences.

On définit une large bande par opposition à une bande étroite. Une bande étroite est une bande sur laquelle sont acquis des signaux dont le spectre est compris dans une plage étroite de fréquences. Par exemple, dans le domaine de la téléphonie, les signaux utilisés ont une bande étroite dont le spectre est compris dans la bande de fréquences allant de 300 Hz à 3400 Hz.

Dans la présente invention, la bande est large aux vues des capacités d'échantillonnage des convertisseurs analogique-numérique actuels. Ainsi, le spectre du signal acquis sur la large bande de fréquences peut s'étendre de 0 Mhz à 100 GHz et plus particulièrement de 500 MHz à 18 GHz.

Chaque signal est émis sur une bande de fréquences caractérisée par une largeur de bande de fréquences. Par exemple, un signal 4G est émis sur une bande de fréquences ayant une largeur de bande pouvant aller jusqu'à 20 MHz, un signal 5G est émis sur une bande de fréquences ayant une largeur de bande pouvant aller jusqu'à 400 MHz et un signal provenant d'un radar monofréquence pulsé est émis sur une bande de fréquences ayant une largeur de bande faible inférieure à 1 MHz.

On entend par « spectre » le graphe représentant l'intensité et la phase d'un signal en fonction de la fréquence.

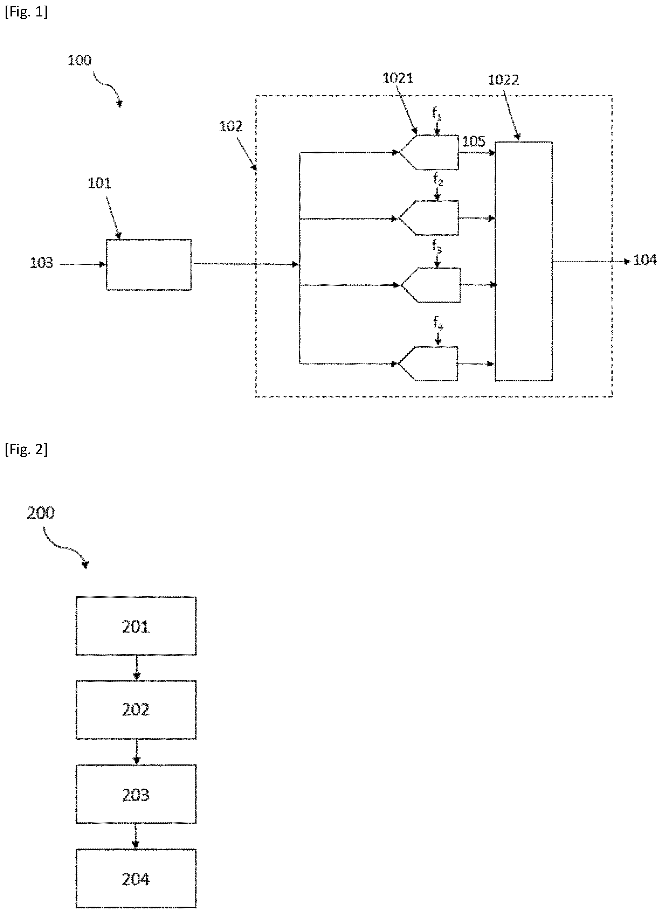

[Fig. 1] montre une représentation schématique du dispositif 100.

Le dispositif 100 comporte un module de réception 101 et un module de traitement 102.

Le module de réception 101 permet de capter les signaux 103 émis dans l'environnement du dispositif 101 sur une large bande de fréquences.

Le module de réception 101 est capable de recevoir plusieurs signaux 103 en même temps sur une large bande de fréquences.

On entend par « recevoir un signal », capter un signal et obtenir le graphe de son intensité en fonction du temps.

Le module de réception est par exemple une antenne ou un réseau antennaire, c'est-à-dire un système comportant au moins deux antennes.

Le module de traitement 102 comporte un ensemble de convertisseurs analogiques-numériques 1021 montés en parallèle permettant d'échantillonner simultanément un signal 103 reçu par le module de réception 101 avec des fréquences d'échantillonnage différentes. Chaque convertisseur analogique-numérique 1021 fournit un signal échantillonné 105 avec une fréquence d'échantillonnage différente.

Sur la figure 1, le module de traitement 102 comporte quatre convertisseurs analogiques numériques 1021. Un premier convertisseur analogique-numérique 1021 échantillonne le signal reçu 103 avec une fréquence d'échantillonnage f₁, un deuxième convertisseur analogique-numérique 1021 échantillonne le signal reçu 103 avec une fréquence d'échantillonnage f₂, un troisième convertisseur analogique-numérique 1021 échantillonne le signal reçu 103 avec une fréquence d'échantillonnage fs et un quatrième convertisseur analogique-numérique 1021 échantillonne le signal reçu 103 avec une fréquence d'échantillonnage f₄.

Le module de traitement 102 comporte de manière avantageuse au moins trois convertisseurs analogiques-numériques 1021.

Le module de traitement 102 comporte également une unité de calcul 1022. L'unité de calcul 1022 permet d'obtenir le spectre 104 du signal reçu 103 en fonction du spectre de chaque signal échantillonné 105 fourni par un convertisseur analogique-numérique 1021.

Dans la présente demande, « unité de calcul » renvoie à un dispositif possédant des moyens de stockage et des moyens de calculs sur les signaux numérisés. Des moyens de stockage peuvent par exemple être un disque dur, une mémoire SSD ou une mémoire Flash simple ou à grille, locale ou distante. Des moyens de calculs peuvent être un microprocesseur ou un circuit logique programmable comme un FPGA (pour « Field-Programmable Gate Array »).

Le dispositif selon un premier aspect de l'invention permet de mettre en oeuvre un procédé 200 selon un deuxième aspect de l'invention.

Le procédé 200 permet de déterminer le spectre, sur une large bande de fréquences, d'un signal 103 reçu par le module de réception 101 du dispositif 100.

[Fig. 2] illustre les étapes 201 à 204 du procédé 200.

La première étape 201 du procédé 200 consiste à recevoir, sur une large bande de fréquences, un signal 103 en provenance de l'environnement du dispositif 100. La première étape 201 du procédé 200 est réalisée par le module de réception 101 du dispositif 100.

La deuxième étape 202 du procédé consiste à échantillonner une pluralité de fois le signal 103 reçu par le module de réception 101 pour obtenir une pluralité de signaux échantillonnés 105.

Chaque signal 105 est échantillonné par un convertisseur analogique-numérique 1021 du module de traitement 102 du dispositif 100. Il y a donc autant de signaux échantillonnés 105 que de convertisseurs analogiques-numériques 1021 dans le module de traitement 102.

Chaque convertisseur analogique-numérique 1021 réalise l'échantillonnage du signal reçu 103 avec une fréquence d'échantillonnage ne respectant pas le théorème de Shannon, c'est-à-dire avec une fréquence d'échantillonnage inférieure à deux fois la fréquence maximale de la large bande de fréquences.

Ainsi, pour une large bande s'étendant de 500 MHz à 18 GHz, la fréquence maximale est de 18 GHz.

Les fréquences d'échantillonnage sont par exemple choisies de façon que leur plus petit commun multiple ou PPCM soit plus grand que la fréquence maximale de la large bande de fréquences.

Ainsi, dans le cas où la fréquence maximale de la large bande de fréquences est de 18 GHz, les fréquences 1,7 GHz, 1,8 GHz et 1,9 GHz dont le PPCM est 30 GHz peuvent par exemple être choisies comme fréquences d'échantillonnage

Chaque signal échantillonné 105 est alors soumis au phénomène de repliement de spectre.

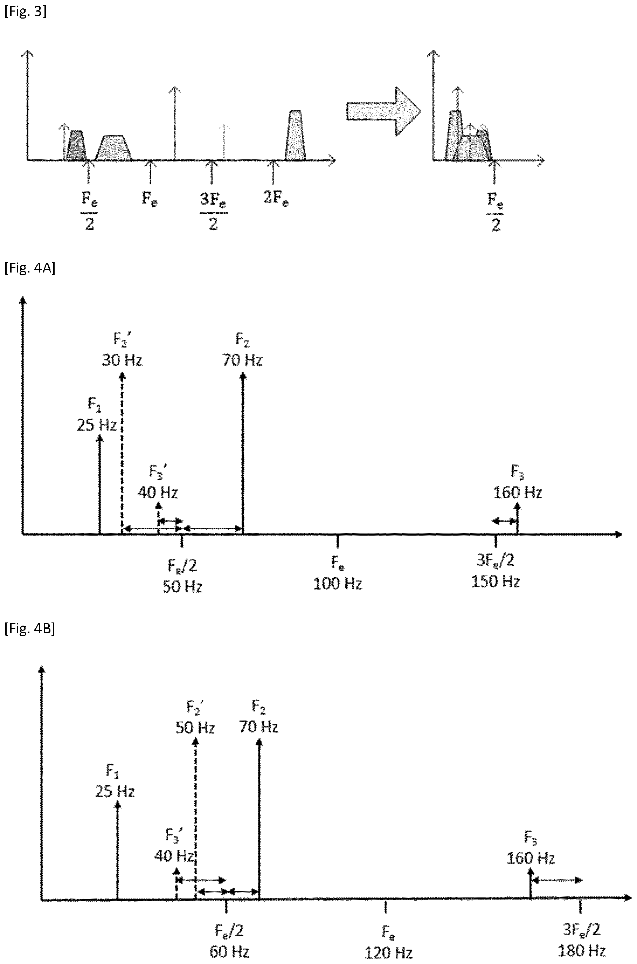

[Fig. 3] illustre le phénomène de repliement de spectre.

Sur la figure 3 est représenté à gauche le spectre réel d'un signal et à droite le spectre du même signal obtenu après échantillonnage avec un fréquence d'échantillonnage Fₑ ne respectant pas le théorème de Shannon.

Le spectre du signal comporte trois fréquences discrètes et trois bandes de fréquences. Une première fréquence discrète et une première bande de fréquences sont situées avant Fₑ/2, une deuxième bande de fréquences est située entre Fₑ/2 et Fₑ, une deuxième fréquence discrète est située entre Fₑ et 3Fₑ/2, une troisième fréquence discrète est située entre 3Fₑ/2 et 2Fₑ et une troisième bande de fréquences située après 2F_{e.}

A cause de la valeur de la fréquence d'échantillonnage Fₑ trop faible, des fréquences images sont introduites dans le spectre du signal échantillonné entre 0 et Fₑ/2 pour chaque fréquence discrète et bande de fréquence du spectre réel située au-delà de Fₑ/2 : c'est le phénomène de repliement de spectre. Ainsi, des fréquences images sont introduites pour les deuxième et troisième fréquences discrètes et les deuxième et troisième bandes de fréquences. Les première fréquence discrète et bande de fréquence n'ont pas de fréquence image puisqu'elles sont déjà comprises dans l'intervalle de fréquences [0 ; Fₑ/2].

De plus, pour chaque fréquence du spectre réel soumise au phénomène de repliement de spectre, l'écart entre la fréquence du spectre donnée et le multiple de Fₑ/2 le plus proche est le même qu'entre la fréquence image correspondante et Fₑ/2.

Ainsi, par exemple, l'écart entre la fréquence image de la troisième fréquence discrète et Fₑ/2 est identique à l'écart entre la troisième fréquence discrète et 3Fₑ/2.

Chaque signal échantillonné 105 est échantillonné avec une fréquence d'échantillonnage Fₑ différente.

La troisième étape 203 du procédé 200 consiste à calculer le spectre de chaque signal échantillonné 105. Cette troisième étape 203 est réalisée par l'unité de calcul 2022.

Le spectre de chaque signal échantillonné 105 est calculé en appliquant une transformée de Fourier au signal échantillonné 105.

La quatrième étape 204 du procédé 200 consiste à déterminer le spectre 104 du signal reçu 103 par le module de réception 101. Cette quatrième étape 204 est réalisée par l'unité de calcul 1022 à partir des spectres des signaux échantillonnés 105 soumis au phénomène de repliement de spectre.

[Fig. 4A] montre un premier exemple de spectre d'un signal reçu échantillonné avec une fréquence Fₑ égale à 100 Hz.

[Fig. 4B] montre un deuxième exemple de spectre du même signal reçu échantillonné avec une fréquence Fₑ égale à 120 Hz.

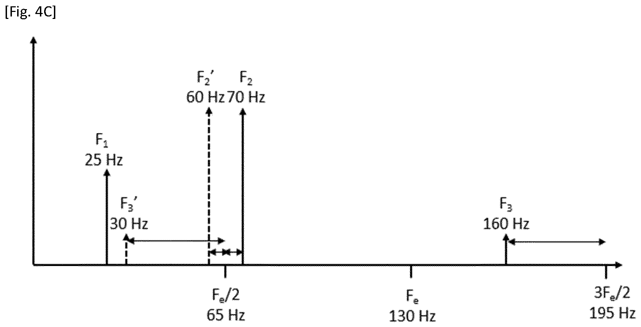

[Fig. 4C] montre un troisième exemple de spectre du même signal reçu échantillonné avec une fréquence Fₑ égale à 130 Hz.

Les trois spectres représentés sont soumis au phénomène de repliement de spectre qui se traduit par la présence des fréquences images entre 0 et Fₑ/2 représentées en pointillés.

Le spectre du signal reçu à déterminer est composé uniquement des fréquences F₁, F₂ et F₃.

Le spectre de la figure 4A comporte deux fréquences images F₂' et F₃'. La fréquence F₂' est la fréquence image de la fréquence F₂ et la fréquence F₃' est la fréquence image de la fréquence F_{3.} En effet, comme expliqué précédemment, dans un spectre soumis au repliement de spectre, chaque fréquence du spectre située au-delà de Fₑ/2 va créer une image entre 0 et Fₑ/2 et l'écart entre la fréquence du spectre et le multiple de Fₑ/2 le plus proche est le même qu'entre la fréquence image correspondante et Fₑ/2.

Ainsi, l'écart entre Fₑ/2 et la fréquence F₂ est égal à l'écart entre Fₑ/2 et la fréquence image F₂'. De même, l'écart entre 3Fₑ/2 et la fréquence F₃ est égal à l'écart entre Fₑ/2 et la fréquence image F₃'.

La fréquence F₁ étant déjà comprise entre 0 et Fₑ/2, elle ne crée pas de fréquence image.

De même, les spectres des figures 4B et 4C comportent deux fréquences images F₂' et F₃', l'écart entre Fₑ/2 et la fréquence F₂ est égal à l'écart entre Fₑ/2 et la fréquence image F₂' et l'écart entre 3Fₑ/2 et la fréquence F₃ est égal à l'écart entre Fₑ/2 et la fréquence image F₃'.

La détermination du spectre 104 du signal reçu 103 est réalisée à partir de l'intervalle de fréquences allant de 0 à Fₑ/2 du spectre de chaque signal échantillonné 105.

En effet, en utilisant des fréquences d'échantillonnages différentes pour les signaux échantillonnés 105 et en recoupant les informations issues des spectres des signaux échantillonnés 105, il est possible de remonter au spectre 104 du signal large bande reçu 103 en étudiant uniquement l'intervalle de fréquences allant de 0 à Fₑ/2.

Pour illustrer le principe de la quatrième étape 204 du procédé 200, prenons l'exemple des spectres des figures 4A, 4B et 4C et faisons l'hypothèse simplificatrice que chaque spectre est compris dans l'intervalle allant de 0 Hz à 200 Hz. Ainsi, dans les trois cas, il y a uniquement deux multiples de la fréquence d'échantillonnage : Fₑ/2 et 3Fₑ/2.

Sur l'intervalle de fréquences allant de 0 à Fₑ/2 du spectre de la figure 4A, il y a trois fréquences : F₁ égale à 25 Hz, F₂' égale à 30 Hz et F₃' égale à 40 Hz.

Il est alors possible de déduire que le spectre 104 recherché comporte au moins trois fréquences, certaines fréquences pouvant se superposer dans l'intervalle allant de 0 à Fₑ/2 sans être identiques, par exemple, une fréquence ayant un écart de 10 Hz avec Fₑ/2 et une autre fréquence ayant un écart de 10 Hz avec 3Fₑ/2.

Il y a alors trois possibilités pour chaque fréquence comprise dans l'intervalle allant de 0 à Fₑ/2 : soit la fréquence appartient vraiment au spectre du signal reçu, soit la fréquence est une fréquence image et correspond à une fréquence du spectre ayant un écart avec un multiple de Fₑ/2 égal à l'écart entre la fréquence image et Fₑ/2, soit les deux.

Si l'on prend l'exemple de la fréquence F₁, soit la fréquence F₁ appartient vraiment au spectre du signal reçu, soit la fréquence F₁ est une fréquence image correspondant à une fréquence ayant un écart de 25 Hz avec Fₑ/2 c'est-à-dire à la fréquence 75 Hz, soit la fréquence F₁ est une fréquence image correspondant à une fréquence ayant un écart de 25 Hz avec 3Fₑ/2 c'est-à-dire soit la fréquence 125 Hz, soit la fréquence 175 Hz, soit une combinaison des propositions précédentes.

Un raisonnement similaire s'applique aux fréquences F₂' et F₃'.

Le tableau suivant présente, pour chaque fréquence de l'intervalle allant de 0 à Fₑ/2 du spectre de la figure 4A, les valeurs possibles pour la fréquence ou les fréquences correspondantes dans le spectre du signal reçu.

**[Tableaux 1]**

| F₁ | F_{2'} | F_{3'} |
|---|---|---|
| 25 Hz | 30 Hz | 40 Hz |
| 75 Hz | 70 Hz | 60 Hz |
| 125 Hz | 130 Hz | 140 Hz |
| 175 Hz | 170 Hz | 160 Hz |

En combinant les informations contenues dans le tableau précédent et obtenues grâce au spectre de la figure 4A avec les informations contenues dans le spectre de la figure 4B, les incertitudes sur le spectre 104 du signal reçu 103 vont diminuer. En effet, la fréquence d'échantillonnage a changé entre le spectre de la figure 4A et le spectre de la figure 4B pour passer de 100 Hz à 120 Hz et les spectres obtenus sont différents.

Le spectre de la figure 4B comprend trois fréquences dans l'intervalle allant de 0 à Fₑ/2 : une fréquence à 25 Hz, une fréquence à 40 Hz et une fréquence à 50 Hz. En étudiant l'amplitude du signal à chacune des fréquences précédentes, il est possible de faire correspondre la fréquence de 25 Hz à la fréquence F₁ du spectre de la figure 4A, la fréquence de 40 Hz à la fréquence F₃' du spectre de la figure 4A et la fréquence de 50 Hz à la fréquence F₂' du spectre de la figure 4A.

Si l'on prend l'exemple de la fréquence F₁, soit la fréquence F₁ appartient vraiment au spectre du signal reçu, soit la fréquence F₁ est une fréquence image correspondant à une fréquence ayant un écart de 35 Hz avec Fₑ/2 c'est-à-dire à la fréquence 95 Hz, soit la fréquence F₁ est une fréquence image correspondant à une fréquence ayant un écart de 35 Hz avec 3Fₑ/2 c'est-à-dire à la fréquence 145 Hz.

Un raisonnement similaire s'applique aux fréquences F₂' et F₃'.

Le tableau suivant présente, pour chaque fréquence de l'intervalle allant de 0 à Fₑ/2 du spectre de la figure 4B, les valeurs possibles pour la fréquence ou les fréquences correspondantes dans le spectre du signal reçu.

**[Tableaux 2]**

| F₁ | F_{2'} | F_{3'} |
|---|---|---|
| 25 Hz | 50 Hz | 40 Hz |
| 95 Hz | 70 Hz | 80 Hz |
| 145 Hz | 170 Hz | 160 Hz |
| | 190 Hz | 200 Hz |

En recoupant les deux tableaux précédents, il est possible de conclure que la fréquence F₁ n'est pas une fréquence image mais une fréquence du spectre ayant une valeur de 25 Hz puisque la valeur 25 Hz est la seule valeur possible présente dans les deux tableaux pour la fréquence F₁.

Il n'est pas possible de conclure pour la fréquence F₂' puisque les deux tableaux présentent deux valeurs en commun : la valeur 70 Hz et la valeur 170 Hz. Ainsi, soit la fréquence F₂' est une fréquence image de la fréquence ayant une valeur de 70 Hz, soit la fréquence F₂' est une fréquence image de la fréquence ayant une valeur de 170 Hz soit les deux.

De même, il n'est pas possible de conclure pour la fréquence F₃' puisque les deux tableaux présentent deux valeurs en commun : la valeur 40 Hz et la valeur 160 Hz. Ainsi, soit la fréquence F₃' appartient au spectre du signal reçu avec une valeur de 40 Hz, soit la fréquence F₃' est une fréquence image de la fréquence ayant une valeur de 160 Hz, soit les deux.

Il faut donc un troisième spectre correspondant au même signal échantillonné avec une fréquence d'échantillonnage différente des deux premières fréquences d'échantillonnage pour conclure. On utilise le spectre de la figure 4C qui correspond au signal échantillonné à une fréquence de 130 Hz.

Le spectre de la figure 4C comprend trois fréquences dans l'intervalle allant de 0 à Fₑ/2 : une fréquence à 25 Hz, une fréquence à 30 Hz et une fréquence à 60 Hz. En étudiant l'amplitude du signal à chacune des fréquences précédentes, il est possible de faire correspondre la fréquence de 25 Hz à la fréquence F₁ du spectre de la figure 4A ou 4B, la fréquence de 30 Hz à la fréquence F₃' du spectre de la figure 4A ou 4B et la fréquence de 60 Hz à la fréquence F₂' du spectre de la figure 4A ou 4B.

Le tableau suivant présente, pour chaque fréquence de l'intervalle allant de 0 à Fₑ/2 du spectre pour une fréquence d'échantillonnage de 130 Hz, les valeurs possibles pour la fréquence ou les fréquences correspondantes dans le spectre du signal reçu.

**[Tableaux 3]**

| F₁ | F_{2'} | F_{3'} |
|---|---|---|
| 25 Hz | 60 Hz | 30 Hz |
| 105 Hz | 70 Hz | 95 Hz |
| 155 Hz | 195 Hz | 160 Hz |

En recoupant les trois tableaux précédents, il est possible de conclure que la fréquence F₂' est une fréquence image correspondant à une fréquence F₂ du spectre ayant une valeur de 70 Hz puisque la valeur 70 Hz est la seule valeur possible présente dans les trois tableaux pour la fréquence F₂'.

De même, il est possible de conclure que la fréquence F₃' est une fréquence image correspondant à une fréquence F₃ du spectre ayant une valeur de 160 Hz puisque la valeur 160 Hz est la seule valeur possible présente dans les trois tableaux pour la fréquence F₃'.

Ainsi, avec un certain nombre de spectres de signaux échantillonnés 105, il est possible de remonter rapidement au spectre 104 du signal reçu 103.

Les fréquences d'échantillonnage peuvent également être choisies supérieures à deux fois la largeur de la bande de fréquences du signal reçu 103. Ainsi, dans le cas d'un signal 4G, les fréquences d'échantillonnage sont choisies supérieures à 40 MHz, dans le cas d'un signal 5G, supérieures à 800 MHz et dans le cas d'un signal provenant d'un radar monofréquence pulsé, supérieures à 2 MHz.

Les fréquences d'échantillonnage peuvent également être choisies de manière à être espacées deux à deux d'une valeur supérieure à deux fois la largeur de bandes du signal reçu 103. Ainsi, dans le cas d'un signal 4G, les fréquences d'échantillonnage sont espacées entre elles d'au moins 40 MHz, dans le cas d'un signal 5G d'au moins 800 MHz et dans le cas d'un signal provenant d'un radar monofréquence pulsé, d'au moins 2 MHz.
Le procédé 200 peut alors comporter une étape supplémentaire d'extraction du signal reçu 103 à partir du spectre d'au moins un signal échantillonné 105, par exemple en appliquant une transformée de Fourier inverse ou par filtrage.

## Revendications

1. Dispositif (100) pour la détermination du spectre (104) d'au moins un signal (103) émis sur une bande de fréquences de signal connue comprise dans une large bande de fréquences comportant :
- un module de réception (101) configuré pour recevoir au moins un signal (103) sur une large bande de fréquences ayant une fréquence maximale ;
- un module de traitement (102) comprenant :
∘ une pluralité de convertisseurs analogiques-numériques (1021) en parallèle configurés pour réaliser l'échantillonnage du signal reçu (103) à des fréquences d'échantillonnage (f₁, f₂, f₃, f₄) différentes pour obtenir une pluralité de signaux échantillonnés (105), les fréquences d'échantillonnage (f₁, f₂, f₃, f₄) étant inférieures ou égales à deux fois la fréquence maximale et supérieures ou égales à deux fois la largeur de la bande de fréquences de signal ;
∘ une unité de calcul (1022) configurée pour déterminer le spectre (104) du signal reçu (103) à partir des spectres des signaux échantillonnés (105) ;
le dispositif (100) étant **caractérisé en ce que** les fréquences d'échantillonnage (f1, f2, f3, f4) sont choisies de manière à être espacées deux à deux d'une valeur supérieure à deux fois la largeur de bandes du signal.

2. Dispositif (100) selon la revendication 1, **caractérisé en ce que** les signaux (103) sont reçues sur une bande de fréquences d'étendant de 0 MHz et 100 GHz.

3. Dispositif (100) selon l'une quelconque des revendications précédentes, **caractérisé en ce que** le module de traitement (102) comprend au moins trois convertisseurs analogiques-numériques (1021).

4. Dispositif (100) selon l'une quelconque des revendications précédentes, **caractérisé en ce que** les fréquences d'échantillonnage (f₁, f₂, f₃, f₄) sont choisies de manière que leur plus petit commun multiple soit plus grand que la fréquence maximale de la large bande de fréquences.

5. Procédé (200) de détermination du spectre (104) d'au moins un signal (103) émis sur une bande de fréquences de signal connue comprise dans une large bande de fréquences ayant une fréquence maximale, mis en oeuvre par le dispositif (100) selon l'une quelconque des revendications précédentes, **caractérisé en ce qu'**il comporte les étapes suivantes :
- une étape (201) de réception du signal (103) réalisée par le module de réception (101) ;
- une étape (202) d'échantillonnage du signal reçu (103) réalisée par chaque convertisseur analogique-numérique (1021) du module de traitement (102), les convertisseurs analogiques-numériques (1021) utilisant des fréquences d'échantillonnages (f₁, f₂, f₃, f₄) différentes, inférieures ou égales à deux fois la fréquence maximale et fournissant chacun un signal échantillonné (105) et supérieures ou égales à deux fois la largeur de la bande de fréquences de signal ;
- une étape (203) de calcul du spectre de chaque signal échantillonné (105) réalisée par l'unité de calcul (1022) ;
- une étape (204) de détermination du spectre (104) du signal reçu (103) à partir des spectres des signaux échantillonnés (105) réalisée par l'unité de calcul (1022).

6. Produit programme d'ordinateur comprenant des instructions qui, lorsque le programme est exécuté par un ordinateur, conduisent celui-ci à mettre en oeuvre le procédé (200) selon la revendication 5.

7. Support d'enregistrement lisible par ordinateur comprenant des instructions qui, lorsqu'elles sont exécutées par un ordinateur, conduisent celui-ci à mettre en oeuvre le procédé (200) selon la revendication 5.

## Patentansprüche

1. Vorrichtung (100) für die Bestimmung des Spektrums (104) mindestens eines Signals (103), das auf einem bekannten Signalfrequenzband gesendet wird, das in einem breiten Frequenzband enthalten ist, die aufweist:
- ein Empfangsmodul (101), das so konfiguriert ist, dass es mindestens ein Signal (103) auf einem breiten Frequenzband, das eine maximale Frequenz vorweist, empfängt;
- ein Verarbeitungsmodul (102), umfassend:
o eine Vielzahl von parallelen Analog-Digital-Wandlern (1021), die so konfiguriert sind, dass sie das Abtasten des empfangenen Signals (103) mit unterschiedlichen Abtastfrequenzen (f₁, f₂, f₃, f₄) durchführen, um eine Vielzahl von abgetasteten Signalen (105) zu erhalten, wobei die Abtastfrequenzen (f₁, f₂, f₃, f₄) kleiner als oder gleich dem Zweifachen der maximalen Frequenz und größer als oder gleich dem Zweifachen der Breite des Signalfrequenzbandes sind;
∘ eine Recheneinheit (1022), die so konfiguriert ist, dass sie das Spektrum (104) des empfangenen Signals (103) aus den Spektren der abgetasteten Signale (105) bestimmt;
wobei die Vorrichtung (100) **dadurch gekennzeichnet ist, dass** die Abtastfrequenzen (f₁, f₂, f₃, f₄) so gewählt sind, dass sie paarweise um einen Wert beabstandet sind, der größer als das Zweifache der Bandbreite des Signals ist.

2. Vorrichtung (100) nach Anspruch 1, **dadurch gekennzeichnet, dass** die Signale (103) in einem Frequenzband empfangen werden, das sich von 0 MHz bis 100 GHz erstreckt.

3. Vorrichtung (100) nach einem der vorstehenden Ansprüche,
**dadurch gekennzeichnet, dass** das Verarbeitungsmodul (102) mindestens drei Analog-Digital-Wandler (1021) umfasst.

4. Vorrichtung (100) nach einem der vorstehenden Ansprüche,
**dadurch gekennzeichnet, dass** die Abtastfrequenzen (f₁, f₂, f₃, f₄) so gewählt sind, dass ihr kleinstes gemeinsames Vielfaches größer als die maximale Frequenz des breiten Frequenzbandes ist.

5. Verfahren (200) zum Bestimmen des Spektrums (104) mindestens eines Signals (103), das auf einem bekannten Signalfrequenzband gesendet wird, das in einem breiten Frequenzband, das eine maximale Frequenz vorweist, enthalten ist, das durch die Vorrichtung (100) nach einem der vorstehenden Ansprüche implementiert wird, **dadurch gekennzeichnet, dass** es die folgenden Schritte aufweist:
- einen Schritt (201) des Empfangens des Signals (103), der durch das Empfangsmodul (101) durchgeführt wird;
- einen Schritt (202) des Abtastens des empfangenen Signals (103), der durch jeden Analog-Digital-Wandler (1021) des Verarbeitungsmoduls (102) durchgeführt wird, wobei die Analog-Digital-Wandler (1021) unterschiedliche Abtastfrequenzen (f₁, f₂, f₃, f₄) verwenden, die kleiner als oder gleich dem Zweifachen der maximalen Frequenz sind, und jeweils ein abgetastetes Signal (105) liefern und größer als oder gleich dem Zweifachen der Breite des Signalfrequenzbandes sind;
- einen Schritt (203) zum Berechnen des Spektrums jedes abgetasteten Signals (105), der durch die Recheneinheit (1022) durchgeführt wird;
- einen Schritt (204) zum Bestimmen des Spektrums (104) des empfangenen Signals (103) aus den Spektren der abgetasteten Signale (105), der durch die Recheneinheit (1022) durchgeführt wird.

6. Computerprogrammprodukt, umfassend Anweisungen, die, wenn das Programm durch einen Computer ausgeführt wird, diesen veranlassen, das Verfahren (200) nach Anspruch 5 zu implementieren.

7. Computerlesbares Aufzeichnungsmedium, umfassend Anweisungen, die, wenn sie durch einen Computer ausgeführt werden, diesen veranlassen, das Verfahren (200) nach Anspruch 5 zu implementieren.

## Claims

1. A device (100) for determining the spectrum (104) of at least one signal (103) transmitted on a known signal frequency band included in a wide frequency band comprising:
- a receiving module (101) configured to receive at least one signal (103) on a wide frequency band having a maximum frequency;
- a processing module (102) comprising:
∘ a plurality of analog-to-digital converters (1021) in parallel configured to sample the received signal (103) at different sampling frequencies (f₁, f₂, f₃, f₄) to obtain a plurality of sampled signals (105), the sampling frequencies (f₁, f₂, f₃, f₄) being less than or equal to twice the maximum frequency and greater than or equal to twice the width of the signal frequency band;
∘ a computing unit (1022) configured to determine the spectrum (104) of the received signal (103) from the spectra of the sampled signals (105);
the device (100) being **characterized in that** the sampling frequencies (f₁, f₂, f₃, f₄) are chosen so as to be spaced apart two-by-two by a value greater than twice the bandwidth of the signal.

2. The device (100) according to claim 1, **characterized in that** the signals (103) are received on a frequency band from 0 MHz to 100 GHz.

3. The device (100) according to any one of the preceding claims,
**characterized in that** the processing module (102) comprises at least three analog-to-digital converters (1021).

4. The device (100) according to any one of the preceding claims,
**characterized in that** the sampling frequencies (f₁, f₂, f₃, f₄) are selected so that their least common multiple is larger than the maximum frequency of the wide frequency band.

5. A method (200) for determining the spectrum (104) of at least one signal (103) transmitted on a known signal frequency band included in a wide frequency band having a maximum frequency, implemented by the device (100) according to any one of the preceding claims, **characterized in that** it comprises the following steps:
- a step (201) of receiving the signal (103), carried out by the receiving module (101);
- a step (202) of sampling the received signal (103) performed by each analog-to-digital converter (1021) of the processing module (102), the analog-to-digital converters (1021) using different sampling frequencies (f₁, f₂, f₃, f₄), less than or equal to twice the maximum frequency and each providing a sampled signal (105) and greater than or equal to twice the width of the signal frequency band;
- a step (203) of calculating the spectrum of each sampled signal (105), carried out by the computing unit (1022);
- a step (204) of determining the spectrum (104) of the received signal (103) from the spectra of the sampled signals (105), carried out by the computing unit (1022).

6. A computer program product comprising instructions that, when the program is executed by a computer, lead the latter to implement the method (200) according to claim 5.

7. A computer-readable recording medium comprising instructions that, when executed by a computer, lead the latter to implement the method (200) according to claim 5.
